# EUROPEAN PATENT APPLICATION

(11) **EP 1 879 202 A2**
(43) Date of publication of application: **16.01.2008**
(21) Application number: 07252795.5
(22) Date of filing: 12.07.2007
(51) Int. Cl.: H01G 4/12, H01G 4/005

(54) **Thin film dielectrics with co-fired electrodes for capacitors and methods of making thereof**

(30) Priority: 14.07.2006 US 486837
(71) Applicant: E.I. DU PONT DE NEMOURS AND COMPANY, Wilmington Delaware 19898 (US); NORTH CAROLINA STATE UNIVERSITY, Raleigh, NC 27695-8210 (US)
(72) Inventor: Borland, William J., Chapel Hill, North Carolina 27517 (US); Daniels, Patrick, Cary, North Carolina 27513 (US); Face, Dean W., Wilmington, Delaware 19803-2222 (US); Ihlefeld, Jon Frederick, State College, Pennsylvania 16801 (US); Maria, Jon-Paul, Raleigh, North Carolina 27606 (US)
(74) Representative: Towler, Philip Dean

(57) **Abstract**

Methods of making capacitors are disclosed that comprise forming a dielectric layer over a substrate with a first electrode or a bare metallic foil, depositing a top conductive layer over the dielectric layer, and annealing the dielectric layer and the top conductive layer wherein the foil or first electrode, the dielectric, and the conductive layer form a capacitor.

## Description

### FIELD OF THE INVENTION

The technical field is embedded capacitors. More particularly, the technical field includes capacitors having thin film dielectrics with co-fired electrical contacts.

### BACKGROUND OF THE INVENTION

The practice of embedding capacitors in printed wiring boards (PWB) allows for reduced circuit size and improved circuit performance. Capacitors are typically embedded in panels that are stacked and connected by interconnection circuitry, the stack of panels forming a printed wiring board.

The fabrication of fired-on-foil high dielectric constant thin-film capacitors is disclosed in U.S. Patent 7,029,971 to Borland et al. Fired-on-foil thin-film capacitors are formed by first depositing a thin capacitor dielectric precursor material layer onto a metallic foil. The metallic foil substrate may be copper foil and typically may range in thickness between 12 and 36 microns. The deposited thin-film capacitor dielectric material is subjected to a firing or annealing process to crystallize the dielectric and increase the grain growth and consequently the dielectric constant. The firing process may be conducted at high temperatures, such as 900°C, in a reduced oxygen atmosphere to avoid oxidation of the underlying metallic foil. After firing, the dielectric layer will generally be a homogenous ceramic layer and may have a thickness of approximately 0.5-1.0 microns. A metallic electrode is next deposited over the fired-on-foil thin-film ceramic capacitor dielectric layer.

Embedded capacitors are subject to requirements such as acceptable breakdown voltage, low leakage current, stability of capacitance within specified temperature ranges, low dielectric loss, construction from environmentally acceptable materials, high yield, simplicity of manufacture, and amenability to printed circuit board manufacturing techniques.

The fabrication of thin-film capacitors in high yield over large areas, such as 30 mm by 30 mm, is generally limited by the defect density in the dielectric thin-film caused by the presence of cracks, porosity, voids, and pinholes, for example. These defects generally limit the size of such capacitors to less than a few mm. U.S. Patent 7,011,726 to Palanduz, for example, identifies these limitations to yield for current thin film capacitor technologies and the need to develop alternative approaches.

Thus, a problem to be solved in present electronic circuitry is the production of large area fired-on-foil capacitors in high yield while maintaining other desirable properties, such as high capacitance density. The methods of the prior art, where the top electrode is deposited after annealing of the dielectric thin film, allow the top electrode metal to penetrate into cracks, defects, and other exposed microstructural features of the annealed thin film.

Accordingly, one mechanism for solving the problem of making large area capacitors in high yield is by depositing the top electrode of the capacitor prior to high temperature annealing of the thin film dielectric. The method of the present invention enables the fabrication of large area thin film capacitors with high yield.

### SUMMARY OF THE INVENTION

According to a first embodiment, a method of making a capacitor comprises forming a dielectric layer over a bare metallic foil, depositing a top conductive layer over the dielectric layer, and annealing the dielectric layer and the top conductive layer at the same time, wherein the foil, the dielectric, and the conductive layer form a capacitor.

According to another embodiment, a method of making a capacitor comprises forming a thin metal layer over a substrate, forming a dielectric over the metal layer, depositing a top conductive layer over the dielectric layer, and annealing the dielectric layer and the top conductive layer on top at the same time, wherein the substrate, the metal layer, the dielectric, and the top conductive layer form a capacitor. The substrate in this embodiment may be a metal, a metal foil, a ceramic, a semiconductor, or an insulator.

Capacitors constructed according to the above methods can be manufactured in high yield over large areas and are suitable for embedding into printed wiring board innerlayer panels, which may in turn be incorporated into printed wiring boards. The capacitors have high capacitance densities, low loss tangents, and other desirable electrical and physical properties.

According to common practice, the various features of the drawings discussed below are not necessarily drawn to scale. Dimensions of various features and elements in the drawings may be expanded or reduced to more clearly illustrate the embodiments of the invention.

### BRIEF DESCRIPTION OF THE DRAWINGS

The detailed description will refer to the following drawings, wherein like numerals refer to like elements, and wherein:
FIG. 1 is a plot of fired-on-foil capacitor yield versus sputtered platinum top electrode diameter wherein the dielectric was annealed prior to application of the platinum top electrode (conventional processing). The data also compare fired-on-foil capacitor yield using conventional processing with very smooth foil and industry standard rough foil.
FIG. 2 is a plot of fired-on-foil capacitor yield versus sputtered platinum top electrode diameter for cofired and conventional processing.
FIG. 3 is a plot of capacitance and loss value versus frequency for a fired-on-foil capacitor with a cofired 20 mm by 20 mm sputtered platinum top electrode.
FIG. 4 is a plot of the capacitance (solid dot data) and dissipation factor (diamond data points) versus applied voltage for a fired-on-foil capacitor with a cofired 2 mm diameter sputtered top copper electrode.
FIG. 5 is a plot of fired-on-foil capacitor yield versus evaporated copper top electrode thickness for 2 mm diameter cofired electrodes.
FIG. 6 is a plot of capacitance and loss factor versus bias for a sputtered capacitor with a 2 mm evaporated cofired top copper electrode.
FIG. 7 is a plot showing various X-ray data of heat-treated chemical solution deposited films of barium titanate on copper foils.
FIG. 8 is a plot of capacitance and loss factor versus frequency for a 3 mm cofired sputtered top platinum electrode on a burnt out chemical solution derived barium titanate film.

### DETAILED DESCRIPTION OF THE INVENTION

Described herein are methods of making high yield thin-film capacitors on metallic foils and metal coated substrates with large area electrodes via cofiring the dielectric with the top electrode.

As used herein, loss factor is equivalent to dissipation factor and tan delta (δ), and high dielectric constant is equivalent to high dielectric permittivity and refers to a value of greater than 500. Also, as used herein, firing is equivalent to annealing and large area electrodes or capacitors refers to electrode diameters equal to or greater than 2 mm and high yields refers to yields above 60%.

The thin-film dielectrics on metal foil or metal coated substrates may be prepared by a variety of deposition techniques including sputtering and chemical solution deposition. When processed with large area electrodes, the cofired thin-film capacitors described herein have high yields. The thin-film dielectrics have fired thicknesses in the range of 0.5-1.0 µm and have acceptable capacitance densities.

The capacitance density of a dielectric is proportional to its permittivity (or dielectric constant K), divided by the thickness of the dielectric. A high capacitance density capacitor can therefore be achieved by using a thin-film, high dielectric constant ("high K") dielectric in the capacitor.

High K ferroelectric dielectrics include perovskites of the general formula ABO₃, such as crystalline barium titanate (BT), lead zirconate titanate (PZT), lead lanthanum zirconate titanate (PLZT), lead magnesium niobate (PMN) and barium strontium titanate (BST). The thin film, high dielectric constant dielectric layer of the methods of the present invention may comprise one or more high K ferroelectric dielectrics:

Substituent and dopant cations may be added to the high dielectric constant material to improve the dielectric properties. The properties desired in the thin-film capacitor will dictate the particular combination of added dopants.

Small quantities of suitable dopants include rare earth cations having the preferred oxide stoichiometry of R₂O₃, where R is a rare earth cation (e.g., Y, Ho, Dy, La, Eu). Rare earth dopants improve insulation resistance in the resulting dielectric.

Transition metal cation dopants such as Mn and Fe may also be used to improve the resistance to reduction in the dielectric and improve the insulation resistance. Other transition metal cations with the preferred oxide stoichiometry of MO₂, where M is a metal, such as Zr, Hf, Sn, Ce, may also be suitable dopant cations. These transition metal cations smooth the temperature-dependence of permittivity in the dielectric by "pinching", i.e., shifting, the three phase transitions of BaTiO₃ closer to one another in temperature space.

Metal cations having the preferred oxide stoichiometry of MO, where M is an alkaline earth metal such Ca, Sr, Mg, may also be used to shift the dielectric temperature maxima to lower temperatures, further smoothing the temperature-dependent response of the dielectric.

The above-described dopants, or mixtures thereof, may be used with the perskovite, e.g., BaTiO₃ or BaSrTiO₃ in various concentrations. A preferred range of concentrations is between about 0 and 5 mole percent of the final formulation.

High K thin film dielectric materials can be deposited by a broad range of deposition methods including chemical solution deposition (CSD), chemical vapor deposition (CVD), evaporation, and sputtering. To obtain high K in these dielectric films, a high temperature, post deposition annealing step is required to achieve crystallization and crystal growth in the thin-film dielectric. The annealing step may be conducted at 800°C or higher. In one embodiment, for use with copper foil, 900°C for 30 minutes was utilized. The annealing may be undertaken under a reduced oxygen atmosphere to avoid oxidation of the metallic electrode if a base metal is utilized.

Since crystalline barium titanate and barium strontium titanate display high dielectric constants and are lead free, these are particularly useful to fabricate large area capacitors with high yield. Consequently, described herein are methods of making capacitors that comprise high yields. The dielectric is formed over the bottom electrode. The bottom electrode may be a metallic foil or an electrode deposited on a ceramic substrate. The top electrode is deposited over the dielectric and the whole structure is cofired to form the final capacitor. These capacitors have high yields with large area electrodes.

One embodiment of the present invention provides a method of making a capacitor, comprising: providing a metal foil; forming a dielectric layer over the metal foil; forming a top electrode over the dielectric; and annealing the metal foil, dielectric and top electrode; wherein upon annealing the metal foil, dielectric and top electrode form a high capacitance density capacitor. In a further embodiment, the dielectric layer above is formed by chemical solution deposition or sputtering. In yet a further embodiment of the invention, the top electrode above is formed by sputtering or evaporation.

As noted above, sputtering and chemical solution deposition (CSD) techniques may be used to form the capacitor dielectrics and sputtering and evaporation techniques may be used to form the top electrodes by the methods described herein above and below.

### Sputter Deposition of the Dielectric

The barium strontium titanate target composition defines the composition of the dielectric formed over the first electrode. In one embodiment a target composition is Ba_{0.75}Sr_{0.25}TiO₃ and in another a doped version, namely Ba_{0.5}Sr_{0.5}Nb_{0.004}Mg_{0.0036}Mn_{0.0014}Ti_{0.988}O₃, is used.

### Chemical Solution Deposition of the Dielectric and Heat Treatment

The chemical precursor solution contains the desired amount of each component of the desired high dielectric constant material as well as additives useful for achieving other goals, for example, the elimination of cracks. Thus, if the desired high dielectric constant material is barium titanate, the chemical precursor solution may comprise barium acetate and titanium isopropoxide.

Pure BaTiO₃ may be prepared from the following chemicals in their respective amounts:

| | |
|---|---|
| Barium acetate | 5.12 grams |
| Titanium isopropoxide | 5.68 grams |
| Acetylacetone | 4.12 milliliters |
| Acetic acid | 43.52 milliliters |

The acetic acid is a dissolving medium for the barium acetate and the titanium isopropoxide, and the acetylacetone is a stabilizing agent for titanium isopropoxide. Diethanolamine (DEA) may be added in the range of 8-12% of the weight of barium acetate in order to prevent cracking in the dielectric film. Thus, for example, to the precursor solution of the preceding paragraph, the DEA addition may total 0.58 g.

The precursor solution is deposited over the copper foil substrate. Suitable solution deposition methods include dip, slot die, gravure, spray, or spin coating. In one embodiment, spin coating was utilized and the rotation time and speed used was 30 seconds at 3000 revolutions per minute.

After deposition, the substrate containing the precursor solution may be dried to remove solvents. Additional depositions may be applied to build the thickness up to the desired value. In one embodiment, a drying temperature of 250°C for 5-10 minutes was used and six consecutive deposition and drying steps were used to achieve the final desired thickness.

After the desired dried thickness has been achieved, the substrate may be heat-treated at a higher temperature to burn out and remove all or the vast majority of the organic components left in the dried solution deposited film. The heat-treatment temperature is high enough to burn out and remove the organic material but not high enough to substantially crystallize the inorganic dielectric. When heat treated, the dried dielectric decomposes to initially form very fine particles of barium and titanium oxides, carbonates, oxycarbonates and mixtures thereof, and then subsequently the carbonates and oxycarbonates decompose and the remaining oxide mixtures react to form barium titanate. In one embodiment, a temperature of 650°C for 30 minutes, in a suitably reducing atmosphere that protected the underlying copper foil was utilized.

### Electrode Deposition

A top electrode is formed over the resulting dielectric. The foil serves as the bottom electrode of the capacitor formed by this method. The top electrode can be formed by, for example, sputtering, printing, evaporation or other suitable deposition methods. In one embodiment, sputtered platinum top electrodes are used. In another copper top sputtered electrodes are used.

### Annealing

After deposition of the top electrode, the coated substrate is annealed. Annealing densifies and crystallizes the deposited dielectric. Annealing may be conducted at a high temperature in a low oxygen partial pressure environment for dielectrics deposited on a metallic foil substrate. The annealing temperature should be lower than the melting point of the metallic foil substrate. A suitable total pressure environment is about 1 atmosphere. In one embodiment, copper foil is used as the substrate, the furnace temperature is about 900°C, and the oxygen partial pressure is approximately 10⁻¹² atmospheres. The annealing may be performed by ramping the furnace up to 900°C at a rate of about 30°C/minute. The furnace is typically maintained at 900°C for 30 minutes.

The annealing temperature of 900°C described above facilitates the use of copper foil as the substrate and allows for crystallization of the deposited dielectric.

Favorable results may also be obtained at annealing temperatures higher than 900°C. Higher temperatures, for example 1200°C, combined with the appropriate atmosphere to avoid oxidation of the metallic substrate, facilitate the use of various metallic substrates, such as nickel. Additionally, if the chemistry of the substrate so permits, annealing may be conducted in air, thereby dispensing with a reducing atmosphere. Such substrates may include precious metal foils or ceramic oxide compositions with precious metal electrodes deposited upon them.

The low oxygen partial pressure may be achieved by bubbling high purity nitrogen through a controlled temperature water bath. Other gas combinations such as additions of small amounts of hydrogen containing forming gas to the gas mixture are also possible. The water bath may be at a temperature of about 25°C.

The above-described annealing process for capacitors generally avoids oxidation of the copper foil or electrode to Cu₂O or CuO. Oxidation is avoided by selecting an appropriate low oxygen partial pressure for the high processing temperature used during annealing. A range of oxygen partial pressures that reliably avoids oxidation of copper and does not deleteriously reduce the dielectric is between 1x10⁻⁹ and 1x10⁻¹⁴ atmospheres. Consequently, high quality BaTiO₃, BaSrTiO₃, or other high dielectric constant layers may be formed in the absence of any oxidation of the copper foil or severe dielectric degradation during annealing. Alternative metallic foils and annealing temperatures may require different atmospheres. These atmospheres may be calculated from the standard free energy of formation of oxides as a function of temperature as described by F.D. Richardson and J.H.E. Jeffes, J. Iron Steel Inst., 160: 261 (1948).

### Re-oxygenation

The capacitor may optionally be subjected to a re-oxygenation process to improve insulation resistance of the dielectric. Re-oxygenation may correspond to a 30 minute anneal at 450°C, at an oxygen partial pressure of approximately 10⁻⁴ atmospheres. Re-oxygenation can be integrated into the cooling step of the annealing, for example, or performed as a separate step after cooling. If appropriate acceptor dopants are used as described previously, the re-oxygenation step may be dispensed with. Such acceptor dopants include manganese, magnesium, etc.

The following examples illustrate favorable properties in dielectrics prepared according to the present invention, and the capacitors incorporating the dielectrics.

### EXAMPLES

### Example 1

A 1 micron thick barium strontium titanate (Ba_{0.75}Sr_{0.25}TiO₃) dielectric precursor thin film was deposited onto a 2" x 1" (5.1 cm x 2.5 cm) clean 0.5 oz (14 g) copper foil by magnetron sputtering. The copper foil was industry standard PLSP copper foil obtainable from Oak Mitsui Corporation. The dielectric precursor was deposited onto the smoother side or "drum" side of the copper foil. The RMS value of the copper foil was measured over an area of 5 µm by 5 µm and 20 µm by 20 µm and found to be 12 nm and 20 nm respectively. Deposition was undertaken at a pressure of 10 mTorr (1.3 Pa) using an Ar:O₂ ratio of 5:1 and a substrate temperature of 130°C. The sputter target diameter was 4 inches (10.2 cm) and the foil to target distance was 8.5 cm. The sputter source was arranged using a 25° "off-axis" geometry. The rf sputtering power was 300 watts and the deposition time was 120 minutes. After deposition, the dielectric film was annealed at 900°C for 30 minutes in a nitrogen-based atmosphere with an oxygen partial pressure of approximately 10⁻¹² atmospheres. An array of platinum top electrodes was deposited on top of the annealed dielectric layer by magnetron sputtering through a shadow mask. The shadow mask contained 20, 24, 24, 28, 21, 21 samples of each of 3 mm, 2 mm, 1 mm, 0.75 mm, 0.5 mm, 0.25 mm diameter electrodes respectively. The platinum electrode thickness was approximately 0.15 µm.

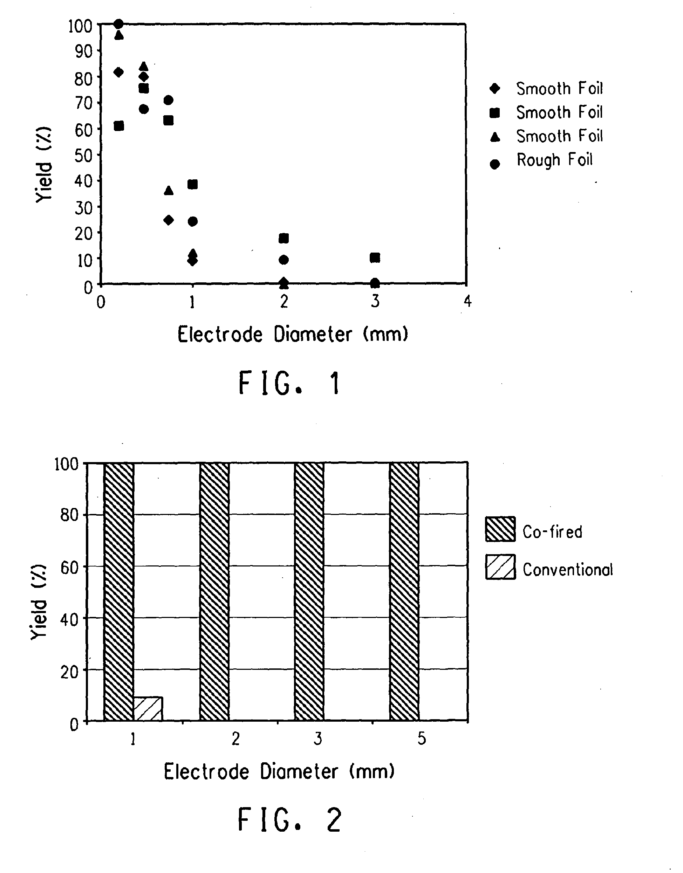

After deposition of the platinum electrodes, the capacitance and loss factor of the capacitors were measured for the 0.25, 0.5, 0.75, 1, 2 and 3 mm diameter capacitors using a Hewlett Packard 4192A LF impedance analyzer. Capacitors were tested at both 0 and 1 volt bias at both 10 KHz and 1 KHz using an oscillating voltage of 0.05 V. Capacitors that were shorted or exhibited no capacitance or had a loss factor greater than 15% were considered to be unacceptable capacitors and included in the yield loss data. The results are shown in graphic form in FIG. 1 wherein the PLSP foil data is designated as the "rough" foil data. Capacitors with 0.25 mm diameter electrodes had 100% yield but capacitors with 3 mm diameter electrodes had zero yield.

### Example 2

To ascertain if smoothness of the copper foil was a key factor in the low yield, very smooth 15 micron thick copper foils were made by evaporation of copper onto a glass plate. After evaporation, the foils were removed from the glass plate resulting in 2 inch by 1 inch (5.1 cm x 2.5 cm) copper foils. The RMS value of the evaporated copper foil was measured over an area of 5 µm by 5 µm and 20 µm by 20 µm and found to be 1.4 nm and 1.5 nm respectively and was approximately equivalent to that of the glass plate.

A 1 µm thick barium strontium titanate (Ba_{0.75}Sr_{0.25}TiO₃) dielectric precursor thin film was deposited onto the evaporated copper foil by magnetron sputtering using the same conditions as described in Example 1. Three foils were made. After deposition, the dielectric film was annealed at 900°C for 30 minutes in a nitrogen-based atmosphere with an oxygen partial pressure of approximately 10⁻¹² atmospheres. An array of platinum top electrodes was deposited on top of the annealed dielectric layer by magnetron sputtering through a shadow mask. The shadow mask contained 20, 24, 24, 28, 21, 21 samples of each of 3 mm, 2 mm, 1 mm, 0.75 mm, 0.5 mm, 0.25 mm diameter electrodes respectively. The platinum electrode thickness was approximately 0.15 µm.

After deposition of the platinum electrodes, the capacitance and loss factor of the capacitors was measured for the 0.25, 0.5, 0.75, 1, 2 and 3 mm diameter capacitors using the same equipment as used in Example 1. Capacitors that were shorted or exhibited no capacitance or had a loss factor greater than 15% were considered to be unacceptable capacitors and included in the yield loss data. The results are shown in graphic form in FIG. 1 wherein the data for the capacitors produced on the evaporated foil are designated as the "smooth" foil data. Again, capacitors with 0.25 mm diameter electrodes had high yields, but capacitors with 3 mm electrodes showed very low or zero yield.

### Example 3

A 1 µm thick barium strontium titanate (Ba_{0.75}Sr_{0.25}TiO₃) dielectric precursor thin film was deposited onto the drum side of a 2" x 1" (5.1 cm x 2.5 cm) clean 0.5 oz (14 g) PLSP copper foil by magnetron sputtering using the same conditions as used in Example 1.

The dielectric film was annealed at 900°C for 30 minutes in a nitrogen-based atmosphere with oxygen partial pressure of about 10⁻¹² atmospheres. An array of platinum top electrodes with diameters of 1, 2, 3 and 5 mm was deposited on top of the annealed dielectric layer by magnetron sputtering through a shadow mask. The platinum electrode thickness was approximately 0.15 µm.

The results are shown in graphic form in FIG. 2 wherein the data from this experiment are designated "conventional". The yield of working capacitors was approximately 12% for the 1 mm diameter electrode capacitors, but for electrode sizes of 2, 3 and 5 mm diameters the yield of working capacitors was zero.

### Example 4

A 1 µm thick barium strontium titanate (Ba_{0.75}Sr_{0.25}TiO₃) dielectric precursor thin film was deposited onto the drum side of a 2" x 1" (5.1 cm x 2.5 cm) clean 0.5 oz (14 g) PLSP copper foil by magnetron sputtering using the same conditions as used in Example 1.

An array of platinum top electrodes with diameters of 1, 2, 3 and 5 mm was prepared on top of the dielectric layer by magnetron sputtering through a shadow mask. The platinum electrode thickness was approximately 0.15 µm. The dielectric film with platinum top electrodes was annealed at 900°C for 30 minutes in a nitrogen-based atmosphere with an oxygen partial pressure of about 10⁻¹² atmospheres.

The results are shown in graphic form in FIG. 2 wherein the data from this experiment are designated "co-fired" and show the yield of working capacitors was 100% for all of the 1, 2, 3 and 5 mm diameter electrodes. The average capacitance and loss values for each of the electrode diameters for a randomly selected series of capacitors are given in Table 1.

**Table 1**

| **Electrode Diameter (mm)** | **Average Capacitance (nF)** | **Average Loss** |
|---|---|---|
| **1** | **3.1** | **2.0%** |
| **2** | **10.4** | **2.1%** |
| **3** | **26.5** | **5.6%** |

### Example 5

A 1 µm thick barium strontium titanate (Ba_{0.75}Sr_{0.25}TiO₃) dielectric precursor thin film was deposited onto the drum side of a 4 inch x 1 inch (10.2 cm x 2.5 cm) clean 0.5 oz (14 g) PLSP copper foil by magnetron sputtering using the conditions used in example 1. A 20 mm x 20 mm top electrode contact area was defined by the use of a simple lift-off mask. A platinum top electrode was deposited on top of the dielectric layer and the lift-off mask by magnetron sputtering. The lift-off mask was removed by dissolving it in acetone. The platinum electrode thickness was approximately 0.15 µm. The dielectric film with the 20 mm by 20 mm platinum top electrode was annealed at 900°C for 30 minutes in a nitrogen-based atmosphere with an oxygen partial pressure of about 10⁻¹² atmospheres.

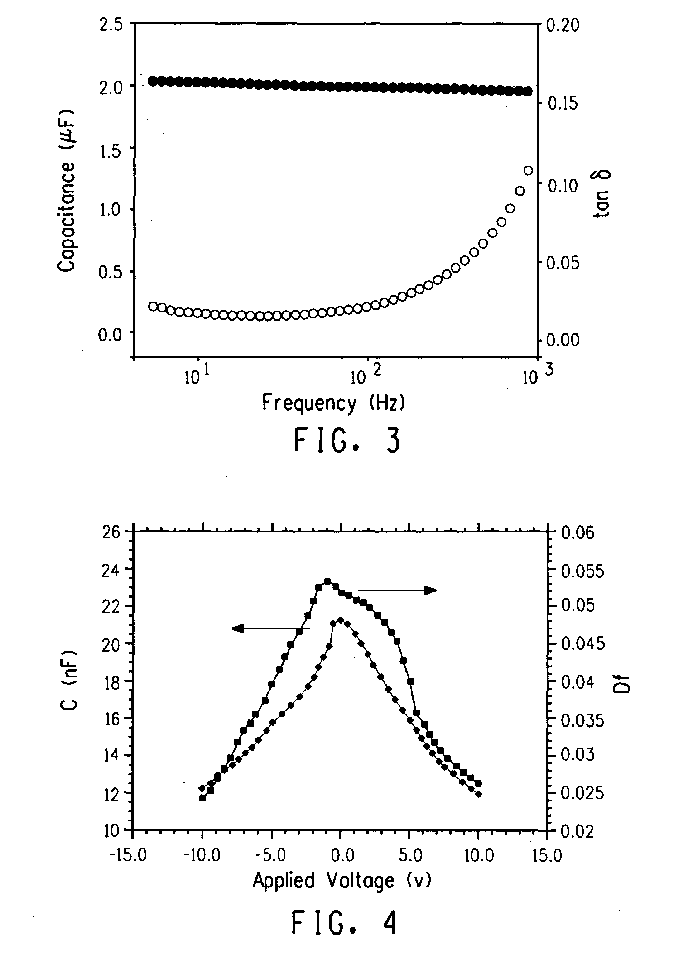

Fig. 3 shows the capacitance and loss vs. frequency for the thin film capacitor with the 20 mm by 20 mm co-fired platinum electrode. The capacitance density is similar to that seen in the smaller capacitors of example 4.

### Example 6

A 5 nm thick chromium adhesion layer film was deposited on a clean polished 3" (7.6 cm) diameter single crystal <100> lanthanum aluminate (LaAIO₃) substrate using rf magnetron sputtering with an argon flow of 40 sccm at a pressure of 10 mTorr (1.3 Pa). Immediately after deposition of the chromium adhesion layer and without breaking vacuum, a 0.5 µm thick copper film was deposited on top of the chromium adhesion layer to form a bottom electrode for the capacitor.

A doped barium strontium titanate (Ba_{0.5}Sr_{0.5}TiO₃) dielectric precursor thin film was then deposited on top of the Cu film by dual magnetron sputtering at a pressure of 20 mTorr (2.7 Pa) using an Ar:O₂ ratio of 9:1. The sputter target diameter was 3 inches (7.6 cm) for each of the sputter sources and the foil to target distance (center to center) was approximately 4 inches (10.2 cm) for each of the two sputter sources. The sputter sources were arranged in "off-axis" geometry with the target surface nearly perpendicular to the foil surface. The rf sputtering power was 150 watts on the one source and 10 watts on the other source. The doped barium strontium titanate target composition was Ba_{0.5}Sr_{0.5}Nb_{0.004}Mg_{0.0036}Mn_{0.0014}Ti_{0.988}O₃ for each sputter source. The deposited film thickness was estimated to be 0.5 µm based on a calibrated deposition rate of 3 nm/min. The deposited film thickness was estimated to be 0.5 µm. The dielectric film was annealed at 900°C for 10 minutes in a nitrogen-based atmosphere with an oxygen partial pressure of about 2x10⁻¹² atmospheres.

A 0.5 µm thick copper top electrode was then sputter deposited onto the surface of the dielectric film through a shadow mask with a pattern of 45 2 mm diameter capacitors and 40 1 mm diameter capacitors.

The 1 and 2 mm capacitors had a yield of 0%.

### Example 7

A 5 nm thick chromium adhesion layer film was deposited on a clean polished 3" (7.6 cm) diameter single crystal <100> lanthanum aluminate (LaAlO₃) substrate using rf magnetron sputtering with an argon flow of 40 sccm at a pressure of 10 mTorr (1.3 Pa). Immediately after deposition of the chromium adhesion layer and without breaking vacuum, a 0.5 µm thick copper film was deposited on top of the chromium adhesion layer to form a bottom electrode for the capacitor.

A doped barium strontium titanate dielectric precursor thin film was then deposited on top of the copper film using the same targets and dielectric deposition conditions used in Example 6. The deposited film thickness was estimated to be 0.5 µm. A 0.5 µm thick copper top electrode was then sputter deposited onto the surface of the dielectric film through the same shadow mask as used in Example 6. The dielectric film with copper top electrode contacts was annealed at 900°C for 10 minutes in a nitrogen-based atmosphere with an oxygen partial pressure of about 2x10⁻¹² atmospheres.

The 1 mm capacitors had a yield of 100%. The average capacitance value for these 36 capacitors was 4.47 nF (0.57 µF/cm²). The average dissipation factor was 3.0%.

The 2 mm capacitors had a yield of 93%. The average capacitance value was 23.1 nF. The average dissipation factor was 1.6%.

Fig. 4 is a plot of the capacitance (solid dot data) and dissipation factor (diamond data points) versus applied voltage for one of the 2 mm capacitors. The data illustrate the expected tunable nature of the dielectric constant for doped Ba_{0.5}Sr_{0.5}TiO₃ dielectric thin films.

### Example 8

A 0.5 µm thick Cu film was deposited on the drum side of a clean 2" x 2" (5.1 cm x 5.1 cm) 0.5 oz (14 g) PLSP copper foil using rf magnetron sputtering using argon at a pressure of 10 mTorr (1.3 Pa). A doped barium strontium titanate (Ba_{0.5}Sr_{0.5}TiO₃) dielectric precursor thin film was then deposited on top of the Cu film by using the same targets and dielectric deposition conditions used in Example 6. The deposited film thickness was estimated to be 0.5 µm.

A 0.5 µm thick ruthenium top electrode was then sputter deposited onto the surface of the dielectric film through a shadow mask with a pattern of 45 2 mm diameter capacitors. The dielectric film with ruthenium top electrode contacts was annealed at 900°C for 10 minutes in a nitrogen-based atmosphere with an oxygen partial pressure of about 2x10⁻¹² atmospheres.

The 2 mm capacitors had a yield of 80%. The average capacitance value was 43.5 nF (1.4 µF/cm²) and the average dissipation factor was 4.4%.

### Example 9

A 0.5 µm thick copper film was deposited on the drum side of a clean 2" x 2" (5.1 cm x 5.1 cm) 0.5 oz (14 g) PLSP copper foil using rf magnetron sputtering using argon at a pressure of 10 mTorr (1.3 Pa).

A doped barium strontium titanate dielectric precursor thin film was then deposited on top of the copper film using the same targets and dielectric deposition conditions used in example 6. The deposited film thickness was estimated to be 0.5 µm.

A 0.5 µm thick copper top electrode was then sputter deposited onto the surface of the dielectric film through the same shadow mask used in Example 6. The dielectric film with copper top electrode contacts was annealed at 900°C for 10 minutes in a nitrogen-based atmosphere with oxygen partial pressure of about 2x10⁻¹² atmospheres.

The 1 mm capacitors had a yield of 100%. The average capacitance value was 6.09 nF (0.75 µF/cm²). The average dissipation factor was 1.7%.

The 2 mm capacitors had a yield of 98%. The average capacitance value was 29.2 nF (0.93 µF/cm²). The average dissipation factor was 1.5%.

### Example 10

A doped barium strontium titanate precursor thin film of the same composition of example 6 was deposited onto the drum side of a 2" x 2" (5.1 cm x 5.1 cm) clean 0.5 oz (14 g) PLSP copper foil by dual magnetron sputtering using the same dielectric deposition conditions as used in Example 6.

The dielectric film was annealed at 900°C for 10 minutes in a nitrogen-based atmosphere with an oxygen partial pressure of about 2x10⁻¹² atmospheres.

A 0.5 µm thick copper top electrode was then sputter deposited onto the surface of the dielectric film through the same shadow mask as used in Example 6.

The 1 mm capacitors had a yield of 11 %. The average capacitance value was 6.32 nF. The average dissipation factor was 5.2%.

The 2 mm capacitors had a yield of 0%.

### Example 11

A 1 micron thick barium strontium titanate (Ba_{0.75}Sr_{0.25}TiO₃) dielectric precursor thin film was deposited onto the drum side of a 2" x 1" (5.1 cm x 2.5 cm) clean 0.5 oz (14 g) PLSP copper foil by magnetron sputtering using the same conditions as used in Example 1.

2 mm diameter copper top electrodes were prepared on top of the dielectric layer by evaporation of copper through a shadow mask. Three samples were prepared, each with a different thickness of evaporated copper. The thicknesses of the copper were 0.4 µm, 0.6 µm and 0.8 µm. The dielectric film with the 2 mm copper top electrodes was annealed at 900°C for 30 minutes in a nitrogen-based atmosphere with an oxygen partial pressure of about 10⁻¹² atmospheres.

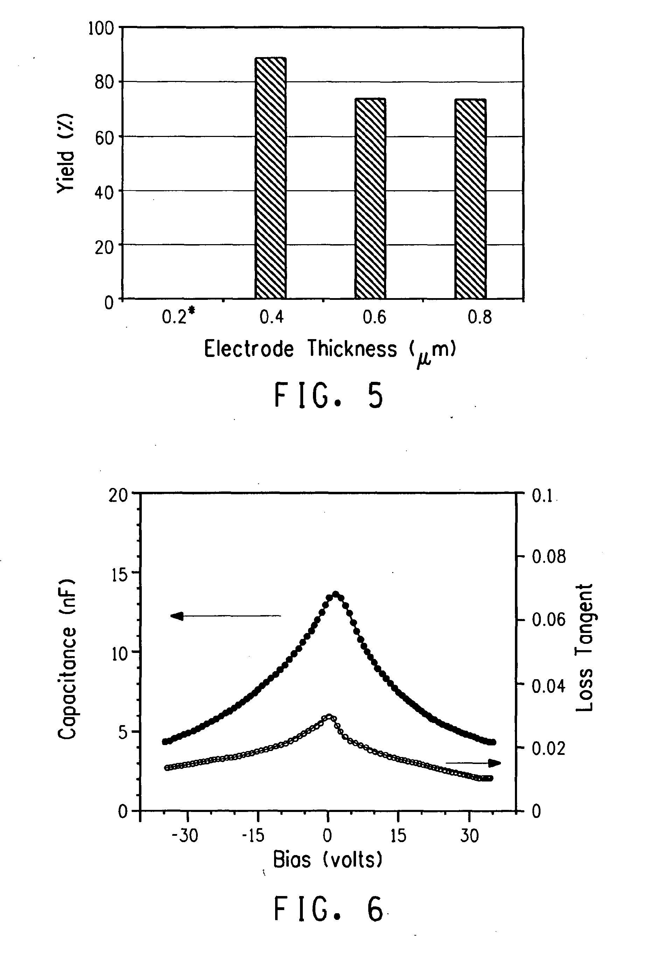

The results are shown in graphic form in FIG. 5 wherein high yield is achieved by use of 0.4 µm thick evaporated copper top electrodes. FIG. 6 shows the capacitance and loss factor versus bias for a 2 mm diameter capacitor with an evaporated copper electrode.

### Example 12

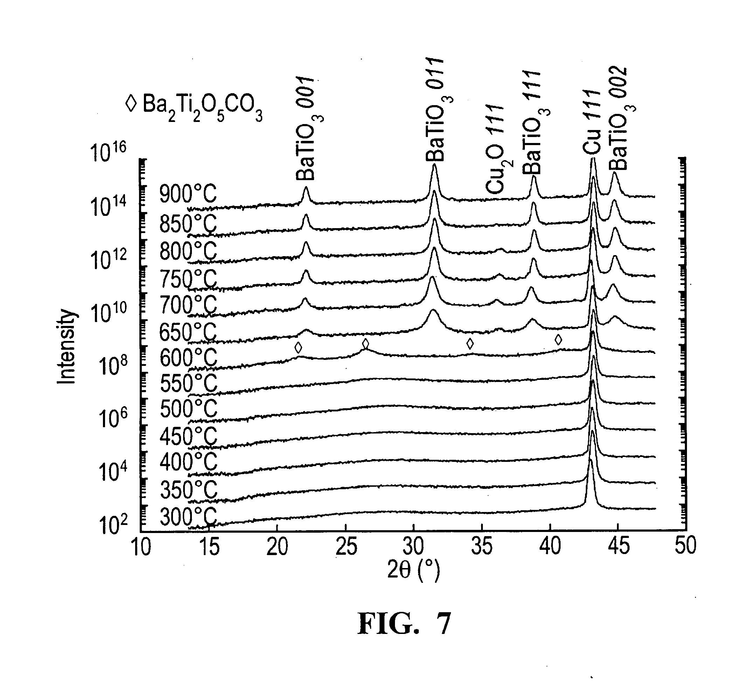

A chemical solution of barium titanate was spun coated on to the drum side of a clean PLSP copper foil. A rotation speed of 3000 rpm for a period of 30 seconds was used. The film was dried at 250°C for 8 minutes. Five more depositions were made by alternating the spin coating and drying. The films were then heat-treated at 650°C for 30 minutes in a nitrogen-based reducing atmosphere with an oxygen partial pressure of approximately 10⁻¹⁷ atmospheres. This temperature was chosen from X-ray diffraction data illustrated in FIG. 7 that shows 650°C is above the temperature for decomposition of barium titanium oxycarbonate (Ba₂Ti₂O₅CO₃) but below that for substantial crystallization of barium titanate.

An array of sixteen 3 mm diameter platinum top electrodes was deposited on top of the heat-treated dielectric layer by magnetron sputtering through a shadow mask. The platinum electrode thickness was approximately 0.1 µm. The burnt out dielectric film with platinum top electrodes was annealed at 900°C for 30 minutes in a nitrogen-based atmosphere with an oxygen partial pressure of about 10⁻¹² atmospheres.

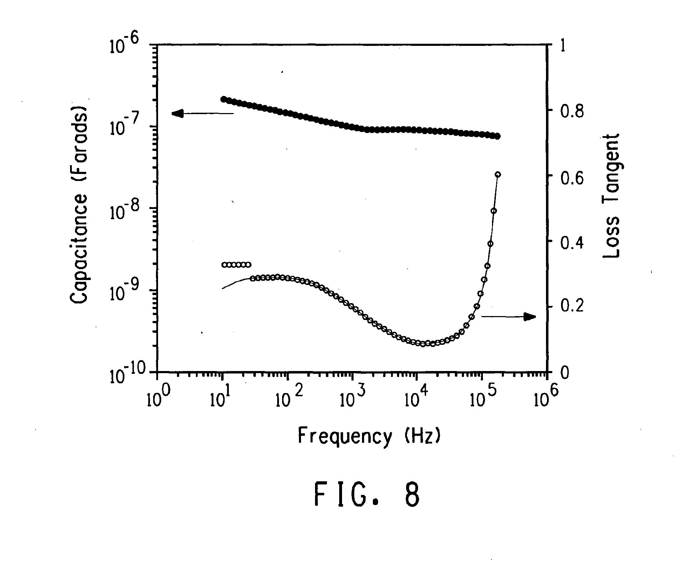

The capacitor yield was 93.75% or 15 out of the 16 measured. The capacitance and loss factor versus frequency of a 3 mm capacitor is shown in FIG. 8.

As detailed in Examples 1, 2, and 3 and shown in FIG. 1 and FIG. 2, conventional processing of sputtered thin films, wherein the top platinum electrode is applied after annealing the dielectric, does not allow for acceptable yields for capacitors with top platinum electrode diameters of greater than 1 mm. Conversely, as detailed in Examples 4 and 5 and as shown in FIG. 2 and FIG. 3, cofiring the top platinum electrode with the underlying dielectric allows for high yield using large area platinum top electrodes.

As detailed in Examples 6 and 10 conventional processing of sputtered thin films, wherein a top copper electrode is applied after annealing the dielectric, does not allow for acceptable yields for capacitors with top copper electrodes. Conversely, as detailed in Examples 7, 9, and 11 cofiring the top copper electrode with the underlying dielectric allows for significantly improved yield. Example 8 also shows that ruthenium electrodes may achieve high yield when a cofiring process is used. Example 11 shows that evaporated copper top electrodes are also usable rather than sputtering and that an optimum thickness is approximately 0.4 µm.

Example 12 shows that the cofiring process yield improvements can be extended to chemical solution deposited films.

The foregoing description of the invention illustrates and describes the present invention. Additionally, the disclosure shows and describes only selected preferred embodiments of the invention, but it is to be understood that the invention is capable of use in various other combinations, modifications, and environments and is capable of changes or modifications within the scope of the inventive concept as expressed herein, commensurate with the above teachings, and/or within the skill or knowledge of the relevant art.

The embodiments described herein above are further intended to explain best modes known of practicing the invention and to enable others skilled in the art to utilize the invention in such, or other, embodiments and with the various modifications required by the particular applications or uses of the invention. Accordingly, the description is not intended to limit the invention to the form disclosed herein. Also, it is intended that the appended claims be construed to include alternative embodiments, not explicitly defined in the detailed description.

## Claims

1. A method of making a capacitor, comprising:
providing a metal foil;
forming a dielectric layer over the metal foil;
forming a top electrode over the dielectric;
and annealing the metal foil, dielectric and top electrode;
wherein upon annealing the metal foil, dielectric and top electrode are cofired to form a high capacitance density capacitor.

2. A method of making a capacitor, comprising:
providing a non-conducting substrate;
forming a first electrode over the non-conducting substrate;
forming a dielectric layer over the first electrode;
forming a top electrode over the dielectric; and annealing the substrate, first electrode, dielectric and top electrode;
wherein upon annealing the substrate, first electrode, dielectric and top electrode are cofired to form a high capacitance density capacitor.

3. The method of claim 1, wherein the metal foil is copper.

4. The method of any preceding claim, wherein the top electrode is platinum, copper or ruthenium.

5. The method of any preceding claim, wherein the dielectric layer is selected from barium titanate, barium strontium titanate, lead zirconate titanate, lead magnesium niobate, lead lanthanum zirconate titanate and mixtures thereof.

6. The method of any preceding claim, wherein the dielectric is a doped composition.

7. The method of any preceding claim, wherein the dielectric has an annealed thickness of between 0.1 and 2 µm.

8. The method of any preceding claim, further comprising the step of re-oxygenating the capacitor.

9. The method of any preceding claim, wherein the dielectric is deposited by sputtering.

10. The method of any one of claims 1 to 8, wherein the dielectric is deposited by chemical solution deposition and undergoes a burn out heat-treatment prior to formation of the top electrode.

11. The method of any preceding claim, wherein the top electrode is deposited by sputtering or evaporation.

12. A printed wiring circuit board, interposer or other organic substrate comprising a capacitor made by the method of any of claims 1 and 3 to 11.

13. A ceramic substrate circuit comprising a capacitor made by the method of any of claims 2 to 11.
